# EUROPEAN PATENT APPLICATION

(11) **EP 0 847 136 A2**
(43) Date of publication of application: **10.06.1998**
(21) Application number: 97121363.2
(22) Date of filing: 04.12.1997
(51) Int. Cl.: H03H 9/21

(54) **Piezoelectric resonator of tuning fork type and method for making same**

(30) Priority: 06.12.1996 JP 327342/96
(71) Applicant: Riken Corporation, Chiyoda-ku, Tokyo (JP)
(72) Inventor: Moronuki, Masaki, c/o Kumagaya Off. Riken Corp., Kumagaya-shi, Saitama (JP)
(74) Representative: Bauer, Friedrich, Dipl.-Ing.

(57) **Abstract**

A piezoelectric resonator of tuning fork type is provided wherein a notch 7 is formed in the symmetrical position of each cantilever 4a, 4b of a substrate 2 in the vicinity of a connection 3 for connecting the cantilevers 4a, 4b. The section area in the tip 4c of each cantilever 4a, 4b is greater than the section area of a notched portion 4d of the cantilever 4a, 4b including the notch 7. The smaller section area and smaller rigidity of the cantilever 4a, 4b at the lower portion 4d cause increased amplitude of the vibrating cantilevers 4a, 4b with a larger Q value upon resonance.

## Description

This invention relates to a vibrator, in particular a piezoelectric resonator of tuning fork type having a pair of cantilevers that can vibrate with their large amplitude.

It is a known phenomenon that a piezoelectric crystal produces its mechanical distortion and polarization respectively when electric field and mechanical stress are applied thereto so that it can be utilized to efficiently convert electric signals or energy into mechanical signals or energy.

Some prior art resonators utilize piezoelectric transducers of tuning fork type each which comprises a substrate made of a metallic material of constant or unchanging elasticity such as Elinvar, and a piezoelectric crystal secured to the substrate. Otherwise a piezoelectric crystal such as quartz may be formed into tuning fork shape without substrate. For example, Japanese Patent Publication No. 47-15639 discloses a low frequency vibrator which comprises a piezoelectric ceramics of bimorph type for drive, a cantilevered resonator secured to the ceramics, and a detecting semiconductor adhered on the resonator operated without any influence by the piezoelectric ceramics on the resonator. This vibrator has its steady structure of semi-eternal service life because the detecting semiconductor is not directly attached to the piezoelectric ceramics. Also, Japanese Patent Disclosure No. 55-41088 exhibits a tuning fork type resonator which comprises a substrate made of a material having its unchanging elasticity such as Elinvar, a pair of thin quartz plates attached to the substrate, a plurality of electrodes formed on the quartz plates to vibrate the substrate by oscillatory distortion of the quartz plates when electric field is applied to the electrodes. The tuning fork resonator of this type indicates its substantially flat frequency characteristic under temperature variation around normal temperature because the quartz plate provides a vibrating source much thinner than the substrate, and the frequency-temperature characteristic of the substrate material becomes dominant, but influence by frequency-temperature characteristic of quartz becomes less.

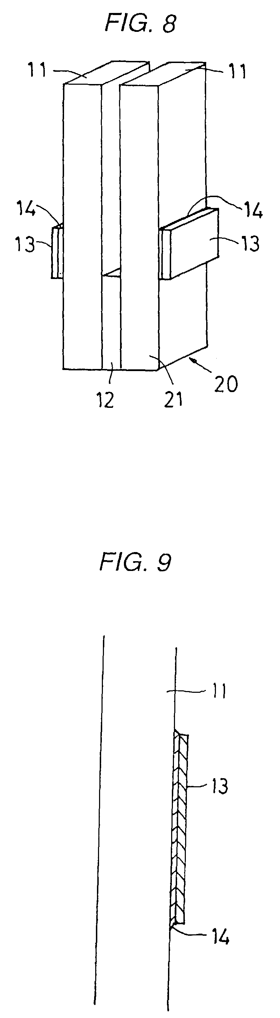

In another aspect, a prior art piezoelectric resonator 20 shown in Figs. 8 and 9 has its tuning fork structure which comprises two cantilevers 11, and a connection 12 for connecting these cantilevers 11 to form a substrate 21 of a U-shape. A piezoelectric material 13 is adhered to each cantilever 11 with bonding agent 14. To measure physical properties of liquid such as viscosity or density, this piezoelectric resonator of tuning fork type is immersed in liquid and input signals are applied to the piezoelectric material 13. In this case, output frequency f of the piezoelectric resonator is shown by the following formula:

f = Aρ^{α}η^{β} +B

where ρ is density of liquid, η is viscosity of liquid, A, α, β and B are constants given by a shape or configuration of the piezoelectric resonator. However, it has been found that it is very difficult to exactly attach the piezoelectric materials 13 in position of two cantilevers 11 in the piezoelectric resonator 20 for good reproducibility. If the piezoelectric material 13 cannot be bonded precisely in position of the cantilever 11, the substrate 21 does not produce good vibrating characteristic to generate correct piezoelectric impedance property representing proper liquid properties. In other words, the resonator is disadvantageous in that the substrate 21 does not vibrate with high Q value (quality factor) and with sufficiently large amplitude.

Should a piezoelectric resonator of tuning fork type have its small quality factor (Q value) and small vibrating amplitude and be immersed in liquid, influence of dumping by density and viscosity of the liquid ceases the vibration of the resonator or narrows the measured range of the viscosity.

An object of the present invention is to provide a piezoelectric resonator of tuning fork type having cantilevers which can vibrate with their large amplitude upon resonance.

Another object of the present invention is to provide a method for making a piezoelectric resonator of tuning fork type wherein piezoelectric transducers can be attached in position of the cantilevers.

The piezoelectric resonator of tuning fork type according to the present invention includes a substrate formed into generally U-shape which comprises a pair of cantilevers and a connection for connecting the cantilevers, and a piezoelectric transducer secured to each of the cantilevers. Each cantilever is provided with a notch formed in the symmetrical position and in the vicinity of the connection so that the section area in a tip of each cantilever is greater than the section area of the cantilever including the notch. Each of the piezoelectric transducers is attached to the notch so that the piezoelectric resonator is suitable for detection of liquid property.

In a vibration system including the cantilevers, the notches are provided in the same or symmetrical position of two cantilevers in the vicinity of the connection. The tip of each cantilever has its section area greater than the section area of the cantilever at the notch so that the rigidity and mass at the notched portion are smaller than those of the tip. The smaller section area of the cantilever at the notched portion provides smaller rigidity and mass which cause increased amplitude of the vibrating cantilevers with a larger Q value upon resonance. Also, it is very easy to surely attach the piezoelectric transducer in position of the substrate because it is secured to the notch formed in the cantilever of the substrate. Such exact attachment of the transducers to the cantilevers realizes a harmonious vibrating property of these cantilevers to generate good impedance characteristics with sufficiently large Q value. Therefore, although the cantilevers are subjected to damping action by liquid, they can continue their stable vibration without shutdown in a wider range of liquid viscosity, thereby resulting in accurate detection of physical properties of liquid.

In an embodiment of the present invention, each of the notches is formed for example by a groove or thicker tip. The notch may have its shape substantially identical with or greater than shape of the piezoelectric transducer which is made of a material selected from a group of piezoelectric ceramics such as titanic acid zircon acid lead (Pb(Zr,Ti)O₃), barium titanate (BaTiO₃), compound perovskite (A(B₁, BH)O₃-PZT), lead titanate (PbTiO₃), niobate (PbNb₂O₆); thin piezoelectric crystal film of zinc oxide (ZnO) and aluminum nitride (AlN); organic piezoelectric high molecular material such as polyvinylidene fluoride (PVDF), copolymer of vinylidene fluoride and trifluoroethylene; thin film of titanic acid zircon acid lead (PZT), barium titanate, and zinc oxide.

The substrate is made of metallic material of constant elasticity under temperature change and selected from a group of Elinvar, Ni-SpanC, Elcolloy, Iso-elastic and Cobenium wherein Young's modulus of the material is substantially unvarying or constant under temperature change.

The method for making a piezoelectric resonator according to the present invention comprises the steps of preparing a pair of cantilevers made of metallic material whose Young's modulus is unvarying; forming a notch at a lower portion of each cantilever with at least a step; bonding a piezoelectric transducer in the notch of the cantilever in contact with the step. A connection may be sandwiched and secured between the cantilevers, or may previously be integrally formed with the cantilevers.

A more complete understanding of the present invention may be derived by reference to the detailed description and the claims when considered together with the accompanying drawings wherein:
Fig. 1 is a perspective view of a piezoelectric resonator of tuning fork type according to the present invention.
Fig. 2 is a partial sectional view of a piezoelectric transducer used in the piezoelectric resonator shown in Fig. 1.
Fig. 3 is an electric circuit for detecting an impedance characteristic of the piezoelectric resonator of tuning fork type.
Fig. 4 is a comparative graph showing impedance characteristics of the invention's and prior art resonators.
Fig. 5 is a perspective view showing a second embodiment of the invention.
Fig. 6 is a perspective view showing a third embodiment of the invention.
Fig. 7 is a perspective view showing a fourth embodiment of the invention.
Fig. 8 shows a prior art piezoelectric resonator of tuning fork type.
Fig. 9 is a partial sectional view of the piezoelectric transducer shown in Fig. 8.

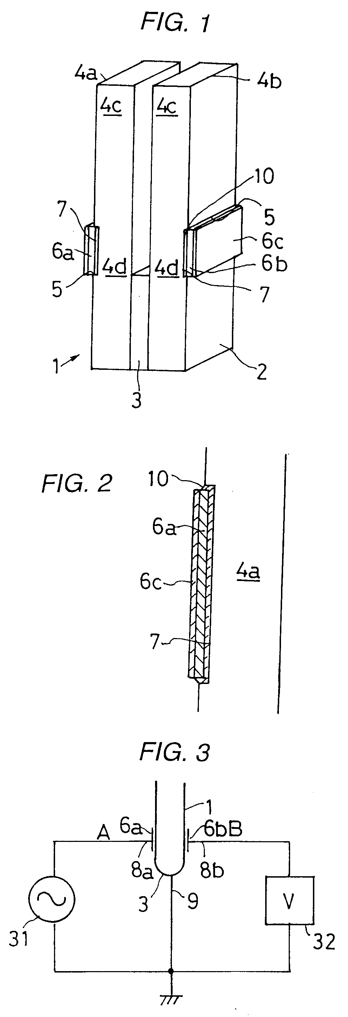

Embodiments of the present invention are described hereinafter in connection with Figs. 1 to 7 of the attached drawings.

As shown in Fig. 1, the piezoelectric resonator 1 of tuning fork type according to the present invention comprises a substrate 2 formed into a tuning fork shape or generally U shape which includes a pair of cantilevers 4a, 4b, and a piezoelectric transducer 6 attached to each cantilever 4a, 4b. The substrate 2 is made of metallic material of constant elasticity wherein Young's modulus of the material is substantially unvarying or constant under temperature change. Such a material is selected from a group of for example Elinvar, Ni-SpanC, Elcolloy, Iso-elastic and Cobenium. Elinvar is a spring material having its low coefficient of thermal expansion and constant coefficient of elasticity, and contains its chemical composition of nickel (Ni) 33-35 %, iron (Fe) 53-61 %, chrome (Cr) 4-5 %, tungsten (W) 1-3 %, manganese (Mn) 0.5-2 %, silicon (Si) 0.5-2 %, and carbon (C) 0.5-2 %. Ni-span C is an alloy of constant coefficient of elasticity, and contains nickel (Ni) 42 %, chrome (Cr) 5.2 %, titanium (Ti) 2.3 %, carbon (C) 0.03 %, manganese (Mn) 0.40 %, silicon (Si) 0.40 %, aluminum (Al) 0.40 %, phosphorous (P) less than 0.04 %, sulfur (S) less than 0.04 %, and balance iron.

A notch 7 is formed by a groove in the symmetrical position or in mirror image of each cantilever 4a, 4b in the vicinity of a connection 3 for connecting the cantilevers 4a, 4b so that the notch 7 forms steps 5 in a boundary between the notch 7 and a tip 4c. Therefore, the section area in the tip 4c of each cantilevers 4a, 4b is greater than the section area of a notched portion 4d of the cantilevers 4a, 4b including the notch 7 which has its shape substantially identical with the piezoelectric transducer 6 secured in each notch 7 of the cantilevers 4a, 4b in this embodiment. The piezoelectric transducers 6a, 6b are made of a material selected from a group of piezoelectric ceramics such as titanic acid zircon acid lead (Pb(Zr,Ti)O₃), barium titanate (BaTiO₃), compound perovskite (A(B₁, BH)O₃-PZT), lead titanate (PbTiO₃), niobate (PbNb₂O₆); thin piezoelectric crystal film of zinc oxide (ZnO), aluminum nitride (AlN); organic piezoelectric high molecular material such as polyvinylidene fluoride (PVDF), copolymer of vinylidene fluoride and trifluoroethylene; thin film of titanic acid zircon acid lead (PZT), barium titanate, and zinc oxide. The substrate 2 is made of metallic material of constant elasticity such as Elinvar, Ni-SpanC, Elcolloy, Iso-elastic and Cobenium wherein Young's modulus of the material is unvarying under temperature change.

In a vibration system including the cantilevers 4a, 4b, the notches 7 are provided in the same or symmetrical position of two cantilevers 4a, 4b in the vicinity of the connection 3. The tip 4c of each cantilever 4a, 4b has its section area greater than the section area at the lower portion 4d of the cantilever 4a, 4b including the notch 7 so that the rigidity and mass at the notched portion 4d is smaller than those of the tip 4c. The smaller section area and smaller rigidity of the cantilever 4a, 4b at the lower portion 4d cause increased amplitude of the vibrating cantilevers 4a, 4b with a larger Q value upon resonance. Also, it is very easy to surely attach the piezoelectric transducer 6 in position of the substrate 2 because it is secured to the notch 7 formed in the cantilever 4a, 4b of the substrate 2. In particular, it is an easy work to attach the piezoelectric transducer 6 between the upper and lower steps 5. When the resonator 1 is immersed and vibrated in liquid, such precise attachment of the transducers 6 to the cantilevers 4a, 4b causes a harmonious vibrating property of these cantilevers 4a, 4b to generate good impedance characteristic with sufficiently large Q value. Therefore, although the cantilevers 4a, 4b are subjected to damping action by liquid, they can continue their stable vibration without shutdown in a wider range of liquid viscosity, thereby resulting in accurate detection of physical properties of the liquid.

In manufacture of the piezoelectric resonator 1, a pair of the cantilevers 4a, 4b are formed of Elcolloy by wire-EDM (Electric Discharge Machining) with the notch 7 having its shape complementary to configuration of the piezoelectric transducer 6 of titanic acid zircon acid lead (PZT). Sandwiched and secured by spot welding between the notched cantilevers 4a, 4b is the connection 3 made of a same material as those of the cantilevers 4a, 4b, and then gaps formed between the connection 3 and cantilevers 4a, 4b are filled with filler metal by brazing to improve propagation of the mechanical vibration between the cantilevers 4a, 4b. Subsequently, two piezoelectric transducers 6 are bonded in the notches 7 between the steps 5 of the cantilevers 4a, 4b through an epoxy adhesive agent 10. The piezoelectric transducers 6 are made of titanic acid zircon acid lead (PZT) formed with top and bottom electrodes. The piezoelectric transducers 6 may be attached in each lower position of the cantilevers 4a, 4b, and in particular advantageously attached on the notched surfaces of the cantilevers 4a, 4b in the vicinity of the connection 3 to produce a maximum amplitude of the tip 4c during vibration of the cantilevers 4a, 4b.

As shown in Fig. 3, a top electrode 6c of one piezoelectric transducer 6a is electrically connected with a signal source 31 of alternative current through a lead wire 8a, and a top electrode 6c of the other piezoelectric transducer 6b is electrically connected with an impedance analyser (HP4192A) 32 through a lead wire 8b. When input signals A of alternative current is applied to the piezoelectric transducer 6a from the signal source 31, the transducer 6 generates stretching vibration in synchronization with the oscillating input signals A so that the substrate 21 can vibrate in response thereto. In other words, the cantilever 4a mechanically vibrates with its natural frequency determined by mechanical properties and shape of the substrate 2 when the transducer 6a generates the stretching vibration. The vibration is transmitted to the other cantilever 4b through the connection 3 so that the mechanical vibration of the other cantilever 4b makes the other piezoelectric transducer 6b produce oscillating displacement and an output B in proportion to the displacement. The output voltage B is detected by the impedance analyzer 32 to measure an impedance characteristic of the vibration system.

It is very important that two cantilevers 4a, 4b have the substantially equivalent vibrating property in the piezoelectric resonator 1 and that there is less attenuation in mechanical vibration transmitted between the cantilevers 4a, 4b. If the input to output ratio (A/B) indicates a good impedance property, the cantilevers 4a, 4b produce a large amplitude during vibration.

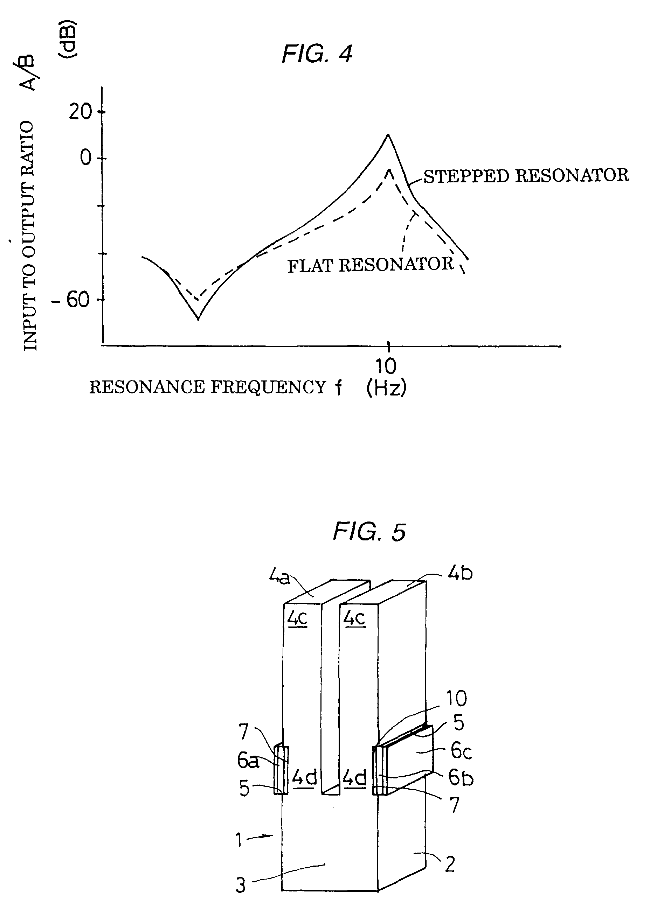

Fig. 5 shows a piezoelectric resonator 1 according to the present invention wherein the cantilevers 4a, 4b and connection 3 are integrally formed of Elcolloy by wire-EDM together with highly accurate notches 7 of the cantilevers 4a, 4b, thereby resulting in improvement in dimension accuracy and productivility.

In a practical embodiment, a piezoelectric resonator 1 of tuning fork type shown in Fig. 5 was prepared with notches 7, and for comparison a prior art piezoelectric resonator was prepared without any notch. Fig. 4 indicates a comparative result of impedance properties of these resonators showing the input to output signal ratio (A/B) with frequency variation of the input signal. As shown in Fig. 4, the resonator 1 with the notches 7 indicates its resonance peak which appears in the vicinity of 10kHz greater by approximately 10 dB (decibel) than the resonance peak of the resonator without notch. This means that the resonator 1 according to the instant invention produces its high Q value with less energy loss at resonance point and with good transmissibility of vibration. It is apparent that the invention's resonator of high Q value can detect a wider range of physical properties of liquid without shutdown although it is subjected to damping action by liquid

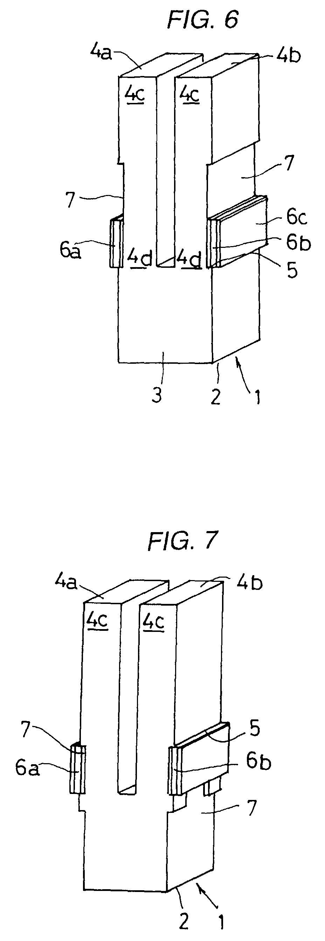

It will be appreciated that modification may be made to the foregoing embodiment of the present invention. For example, the transducers 6a, 6b may be attached to the cantilevers 4a, 4b in contact to at least one of the steps 5 as shown in Fig. 6. Also, as shown in Fig. 7, the notches 7 may be formed by protrusions 1 or thicker tip 4c.

As mentioned above, the piezoelectric resonator of tuning fork type according to the present invention is in particular suitable for detection of liquid property and very advantageous in improving performance of measuring instruments and actuators utilizing the piezoelectric resonator of tuning fork type because it produces a large amplitude of the cantilevers upon resonance.

## Claims

1. A piezoelectric resonator of tuning fork type which includes a substrate formed into generally U-shape, said substrate comprising a pair of cantilevers and a connection for connecting said cantilevers, and a piezoelectric transducer secured to each of said cantilevers,
each of said cantilevers being provided with a notch formed in the symmetrical position and in the vicinity of said connection so that the section area in a tip of each cantilever is greater than the section area of said cantilever including said notch; and
each of said piezoelectric transducers being attached to said notch.

2. A piezoelectric resonator set forth in claim 1, wherein each of said notches is formed by a groove or said thicker tip.

3. A piezoelectric resonator set forth in claim 1, wherein each of said notches has its shape substantially identical with or greater than that of said piezoelectric transducer.

4. A piezoelectric resonator set forth in any one of claims 1 to 3, wherein said piezoelectric transducer is made of a material selected from a group of piezoelectric ceramics such as titanic acid zircon acid lead (Pb(Zr,Ti)O₃), barium titanate (BaTiO₃), compound perovskite (A(B₁, BH)O₃-PZT), lead titanate (PbTiO₃), niobate (PbNb₂O₆); thin piezoelectric crystal film of zinc oxide (ZnO) and aluminum nitride (AlN); organic piezoelectric high molecular material such as polyvinylidene fluoride (PVDF), copolymer of vinylidene fluoride and trifluoroethylene; thin film of titanic acid zircon acid lead (PZT), barium titanate, and zinc oxide.

5. A piezoelectric resonator set forth in any one of claims 1 to 4 used for detection of liquid property.

6. A piezoelectric resonator set forth in any one of claims 1 to 5, wherein said substrate is made of metallic material of constant elasticity under temperature change.

7. A piezoelectric resonator set forth in claim 6, wherein said substrate is made of metallic material whose Young's modulus is substantially unvarying or constant under temperature change.

8. A piezoelectric resonator set forth in claim 7, wherein said substrate is made of metallic material selected from a group of Elinvar, Ni-SpanC, Elcolloy, Iso-elastic and Cobenium.

9. A method for making a piezoelectric resonator comprising the steps of preparing a pair of cantilevers made of metallic material whose Young's modulus is unvarying;
forming a notch at a lower portion of each cantilever with at least a step; and
bonding a piezoelectric transducer in said notch of said cantilever in contact with said step.

10. A method for making a piezoelectric resonator set forth in claim 9, further comprising sandwiching and securing a connection between said cantilevers.

11. A method for making a piezoelectric resonator set forth in claim 9, wherein said cantilevers are previously integrally formed with a connection.
